# FASCICULE DE BREVET EUROPEEN

(11) **EP 0 787 839 B1**
(45) Date de publication et mention de la délivrance du brevet: **12.06.2002**
(21) Numéro de dépôt: 97410013.3
(22) Date de dépôt: 29.01.1997
(51) Int. Cl.: C30B 25/10, C23C 16/46

(54) **Procédé d'étalonnage de température d'un réacteur d'épitaxie**
Verfahren zum Kalibrieren der Temperatur eines Epitaxiereaktors
Process for calibrating the temperature of an epitaxy reactor

(30) Priorité: 31.01.1996 FR 9601369
(43) Date de publication de la demande: 06.08.1997
(73) Titulaire: STMicroelectronics S.A., 92120 Montrouge (FR)
(72) Inventeur: Dutartre, Didier, 38240 Meylan (FR)
(74) Mandataire: de Beaumont, Michel

(56) Documents cités:
- US-A- 5 305 417
- PATENT ABSTRACTS OF JAPAN vol. 17, no. 25 (C-1017), 18 Janvier 1993 & JP 04 247870 A (HITACHI LTD), 3 Septembre 1992,
- PATENT ABSTRACTS OF JAPAN vol. 8, no. 4 (E-220), 10 Janvier 1984 & JP 58 169906 A (NIPPON DENKI), 6 Octobre 1983,

## Description

La présente invention concerne l'étalonnage de réacteurs d'épitaxie, plus particulièrement utilisables dans le domaine de l'industrie des composants semiconducteurs.

On tend actuellement à fabriquer des composants semiconducteurs sur des tranches de plus en plus grands diamètres. On utilise par exemple industriellement des tranches d'un diamètre de 20 centimètres mais des projets sont en cours pour développer des machines aptes à traiter des tranches de diamètres encore supérieurs. Avec des tranches d'un tel diamètre, il redevient intéressant de procéder à des traitements tranche par tranche, notamment pour des traitements de dépôt en phase vapeur, par exemple des dépôts de couches épitaxiées.

Comme on cherche à obtenir un grand nombre de composants identiques sur une même tranche, il est primordial que les dépôts effectués aient les mêmes caractéristiques sur toute l'étendue de la tranche. Pour cela, il faut notamment que la température à laquelle est portée la tranche corresponde à une température choisie et soit uniforme sur toute la tranche.

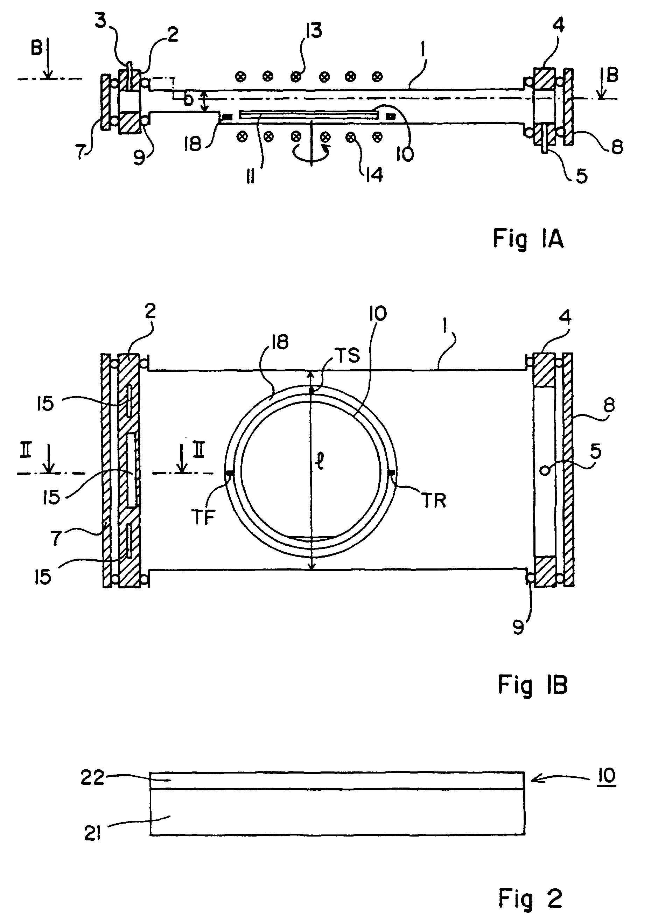

Les figures 1A et 1B représentent de façon extrêmement schématique respectivement une vue de côté et une vue de dessus d'un exemple de réacteur d'épitaxie. Ce réacteur comprend une enceinte de quartz 1 ayant en coupe la forme générale d'un rectangle dont la hauteur h est faible devant sa largeur l. Par exemple, si l'on souhaite traiter des tranches 10 d'un diamètre de 20 cm, il est clair que la largeur doit être supérieure à 20 cm tandis que la hauteur pourra être de quelques centimètres seulement. L'enceinte a également en vue de dessus une forme générale rectangulaire. Des gaz sont introduits au niveau d'un flasque d'injection 2 muni d'un embout d'admission 3 et sont évacués au niveau d'un flasque d'évacuation 4 muni d'un embout d'évacuation 5. Des plaques de fermeture 7 et 8 peuvent être ouvertes pour accéder à l'intérieur du tube, en particulier pour introduire et extraire des échantillons à traiter. Ces divers éléments sont assemblés à pression par l'intermédiaire de joints toriques 9. L'échantillon 10 à traiter, par exemple une tranche de silicium, est posé sur un plateau ou suscepteur 11. Ce plateau est généralement un plateau tournant entraîné en rotation pendant le traitement pour favoriser l'uniformité du dépôt.

Un système de chauffage, par exemple par des lampes chauffantes 13 et 14, est disposé de façon à irradier la face supérieure de l'échantillon et la face inférieure du plateau sur lequel il repose. Les ensembles de lampes 13 et 14 sont chacun divisés en plusieurs sous-ensembles de lampes, par exemple dix, réglables indépendamment, de façon à pouvoir, par un réglage approprié, obtenir une température uniforme de la tranche 10.

Bien entendu, la représentation des figures 1A et 1B est extrêmement schématique et un réacteur réel sera plus complexe que le système représenté. Les plaques de fermeture 7 et 8 seront de préférence associées à des sas d'introduction robotisés. Des systèmes complexes de fourniture de gaz seront prévus. Notamment, un débitmètre massique précis sera connecté en série entre l'embout 3 et la source du ou des gaz de réaction. Pour uniformiser la circulation de gaz dans l'enceinte, on utilise généralement plusieurs fentes d'injection 15 s'étendant dans le sens de la largeur de l'enceinte.

Le réacteur représenté et décrit ci-dessus ne l'a été qu'à titre d'exemple. Des enceintes de quartz ou autre matériau de formes différentes, par exemple à symétrie cylindrique, sont également utilisées.

Un problème qui se pose avec de tels réacteurs d'épitaxie réside dans l'obtention d'un bon réglage des lampes ou autres moyens de chauffage de la tranche de silicium 10.

Il est souvent prévu autour du plateau tournant 11 une bague 18 dont le bord intérieur est extrêmement proche de la périphérie de la tranche de silicium et dont la surface supérieure est sensiblement dans le même plan que la tranche de silicium. Cette bague supporte notamment plusieurs capteurs de température, par exemple trois thermocouples TF, TS et TR, respectivement disposés en amont de la tranche (TF), c'est-à-dire du côté recevant en premier le flux gazeux en écoulement, sur un côté (TS), et en aval de la tranche par rapport à l'écoulement gazeux (TR). De plus, un thermocouple central (non représenté) est généralement disposé dans le suscepteur 11. Toutefois, ces thermocouples ne donnent pas une image exacte de la température de la tranche mais sont portés à des températures, liées notamment à l'écoulement gazeux, distinctes de celles de la tranche. Ces capteurs servent donc seulement d'éléments de correction et de régulation de température. Il existe également des réacteurs d'épitaxie munis de détecteurs de température disposés différemment et/ou de nature différente, par exemple des pyromètres optiques. On utilise aussi des systèmes de contrôle différentiel des puissances injectées dans les diverses zones de chauffe.

Classiquement, dans les divers appareils existants de traitement de tranches de silicium, pour réaliser un étalonnage initial d'un paramètre tel que la température, puis un reréglage périodique, on place dans l'appareil une tranche témoin et l'on soumet cette tranche à un traitement particulier constituant l'un des traitements habituellement réalisé par l'appareil ; on déduit de la structure obtenue à la suite du traitement les éventuels défauts de réglage du paramètre considéré. Par exemple, dans un appareil de dépôt par voie chimique en phase vapeur permettant d'effectuer des dépôts d'oxyde de silicium, on analyse l'épaisseur de la couche d'oxyde en plusieurs points de la tranche et l'on déduit des variations de cette épaisseur les fluctuations du paramètre visé. De même, dans un appareil de recuit thermique rapide (RTA - Rapid Thermal Annealing), qui est normalement destiné à faire des recuits d'activation sur des couches implantées, on place une tranche témoin ayant subi une implantation dans l'appareil et l'on procède à un recuit rapide à haute température puis l'on mesure la valeur de la résistance de la couche implantée et activée en différents points de cette couche. On déduit de variations éventuelles de cette résistance de couche l'existence de variations thermiques.

Toutefois, dans un appareil destiné à réaliser des dépôts par épitaxie, c'est-à-dire des appareils dans lesquels on opère en ambiance non oxydante, si l'on procède à un dépôt d'une couche mince par épitaxie, par exemple un dépôt de silicium polycristallin, les éventuelles inhomogénéités (épaisseur, dopage) de ce dépôt ne dépendront que partiellement de la température mais dépendront aussi de nombreux paramètres tels que la composition des gaz de dépôt et la répartition du flux de gaz sur la surface de la tranche. Il n'est donc pas possible d'isoler l'action du paramètre de température par ce moyen.

En pratique, on s'est aperçu que, si la température d'une tranche de silicium pendant un dépôt par épitaxie était inégale tandis que l'on opère à des températures élevées, l'existence d'inhomogénéités de température entraînait la création dans la tranche de défauts cristallins couramment appelés lignes de glissement ou slip-lines.

En conséquence, un procédé actuellement utilisé pour tester l'uniformité de température dans un réacteur d'épitaxie consiste à y insérer une tranche de silicium témoin, à la soumettre à un cycle thermique jusqu'à une température souhaitée (par exemple 1050°C), puis à retirer cette tranche du réacteur et à analyser les défauts cristallins. L'inconvénient de ce procédé est que, si l'apparition de défauts cristallins révèle l'existence d'inhomogénéités thermiques, il n'y a pas de corrélation simple entre ces inhomogénéités thermiques et les défauts cristallins. Par exemple, quand on voit apparaître une ligne de glissement, on peut seulement en déduire que la température de la tranche de part et d'autre de cette ligne est inégale et qu'il faut modifier le réglage des lampes mais sans savoir si cette modification doit être un accroissement ou une réduction de température. Cette technique conduit donc à des tâtonnements longs avant d'arriver à un réglage permettant l'élimination des lignes de glissement. Même quand on est arrivé à ce résultat, le réglage reste non-idéal. En effet, les défauts cristallins risquent de disparaître dès que le réglage approche d'un réglage optimal sans toutefois être optimal. De plus, certains types d'inhomogénéités thermiques ne produisent pas de défauts cristallins. Par exemple, des variations linéaires de température ne pourront pas être détectées.

Les autres solutions connues pour obtenir un réglage d'uniformité en température sont également peu satisfaisantes. Elles consistent essentiellement à faire des essais en multipliant le nombre de thermocouples fixés à une tranche témoin 10 et au plateau 11 récepteur de cette tranche. Si ces méthodes permettent éventuellement d'effectuer un réglage initial, elles sont mal adaptées à des reréglages périodiques et ne sont pas compatibles avec la rotation de la tranche.

Ainsi, un objet de la présente invention est de prévoir un procédé d'étalonnage en température d'un réacteur d'épitaxie qui soit simple à mettre en oeuvre, fiable et reproductible.

Un autre objet de la présente invention est de prévoir un tel procédé d'étalonnage qui soit particulièrement sensible.

Pour atteindre ces objets, la présente invention prévoit un procédé d'étalonnage en température d'un réacteur d'épitaxie, comprenant les étapes suivantes :
a) préparer une tranche témoin en silicium monocristallin ayant subi sur au moins l'une de ses faces une implantation d'un dopant suivie d'un recuit d'activation pour former une couche diffusée ;
b) mesurer la résistance de couche de ladite couche diffusée en un point de la surface de la tranche ;
c) placer la tranche témoin dans le réacteur d'épitaxie, celui-ci étant réglé à une température visée en présence d'un flux de gaz neutre ; et
d) mesurer à nouveau la résistance de couche au même point et calculer la différence entre les deux valeurs de résistance de couche, cette différence traduisant le cycle thermique subi par la tranche témoin pendant son séjour dans le réacteur d'épitaxie.

Selon un mode de réalisation de la présente invention, la tranche témoin subit un recuit d'activation et un recuit de redistribution en atmosphère oxydante.

Selon un mode de réalisation de la présente invention, la tranche témoin est d'un premier type de conductivité, le dopant étant du deuxième type de conductivité.

Selon un mode de réalisation de la présente invention, la tranche témoin est une tranche faiblement dopée de type P, le dopant étant de l'arsenic.

Selon un mode de réalisation de la présente invention, les mesures de résistance sont effectuées en une pluralité de points de la tranche témoin, les écarts entre les différences de résistance traduisant le cycle thermique subi par la tranche témoin aux points considérés.

Selon un mode de réalisation de la présente invention, le procédé comprend en outre l'étape consistant à ajuster le réglage de moyens de chauffage du réacteur d'épitaxie en fonction des résultats d'étalonnage obtenus.

Ces objets, caractéristiques et avantages, ainsi que d'autres de la présente invention seront exposés plus en détail dans la description suivante d'un mode de réalisation particulier faite à titre non-limitatif en relation avec les figures jointes parmi lesquelles :
les figures 1A et 1B décrites précédemment représentent schématiquement un exemple de réacteur d'épitaxie ; et
la figure 2 représente une plaque témoin utilisée selon la présente invention.

Le procédé selon la présente invention consiste d'abord à utiliser une plaque témoin particulière.

Comme le représente la figure 2, la plaque témoin est une tranche de silicium 21 de type N ou P faiblement dopée. Sur une face de cette tranche, on implante des atomes dopants, de préférence mais non nécessairement, de type opposé à celui de cette tranche, par exemple un dopant de type N tel que de l'arsenic dans une tranche faiblement dopée de type P.

Après l'implantation, on procède à un recuit suffisant pour obtenir une activation complète et éventuellement une redistribution (drive-in) du dopant pour obtenir en surface une couche diffusée 22. On rappellera que, immédiatement après une implantation, les atomes dopants n'ont pas réellement d'effet de création d'une couche d'un type de conductivité défini dans un substrat mais provoquent de très nombreuses dislocations et perturbations du réseau cristallin. On n'obtient réellement une couche dopée d'un type de conductivité donné qu'après un recuit dit d'activation. Après ce recuit d'activation, on procède à un recuit dit de redistribution pour créer une couche dopante d'une profondeur choisie. Selon une caractéristique de l'invention, on procède à cette étape de recuit préparatoire en atmosphère oxydante de sorte que, en même temps que l'on obtient l'activation et la redistribution des atomes dopants, une couche d'oxyde de silicium croît à la surface de la tranche.

On élimine ensuite cette couche d'oxyde et l'on effectue une mesure de résistance de couche par tout procédé connu, par exemple par le procédé dit des quatre pointes, en plusieurs emplacements déterminés de la tranche, par exemple cinquante. On place ensuite la tranche témoin ainsi préparée dans un sas d'admission à un réacteur d'épitaxie à étalonner. Dans ce sas, la tranche est préchauffée puis est insérée automatiquement sur le plateau 11, les lampes 13-14 étant réglées de la façon considérée à ce moment comme optimale pour obtenir une température choisie et une uniformité de cette température (par exemple une température comprise entre 1000 et 1150°C). Pendant cette phase thermique, un gaz neutre est amené à circuler dans l'enceinte selon les débits habituellement utilisés pour des réactions épitaxiales. On entend ici par gaz neutre un gaz n'entraînant aucun dépôt ou croissance de couche sur la plaque témoin 10. Il pourra s'agir d'un gaz porteur couramment utilisé en épitaxie tel que de l'hydrogène ou d'un gaz neutre tel que de l'argon. La pression pourra être une pression réduite ou la pression atmosphérique selon le type de dépôt épitaxial prévu par la suite.

Après cette étape thermique, la tranche témoin est extraite du réacteur. On effectue de nouvelles mesures de résistance de couche aux mêmes emplacements que précédemment et l'on note les différences de résistance.

Les expériences effectuées par la demanderesse montrent que les variations des différences de résistance sont sensiblement proportionnelles aux écarts de température sur la surface de la tranche. En outre, ce procédé s'est avéré être extrêmement sensible comme l'indiquent les valeurs numériques ci-après dans le cas d'un exemple particulier.

### EXEMPLE

Une plaque témoin a été préparée en partant d'une plaque de silicium dopée selon le type de conductivité P par du bore à une concentration de l'ordre 10¹⁵ atomes/cm³. Sur cette tranche, on a effectué un dépôt uniforme d'ions d'arsenic à une dose de 4.10¹⁵ atomes/cm² et sous une énergie de 60 keV. On a ensuite procédé à un recuit d'une durée de quatre heures à 1150°C en atmosphère oxydante d'où il a résulté une couche d'oxyde d'une épaisseur sensiblement égale à 1,6 µm. Après ce traitement, les mesures de résistance de couche donnaient des valeurs de l'ordre de 20 ohms/carré, ces valeurs étant uniformes à mieux que 1/1000 sur toute la surface de la tranche.

On a ensuite placé la tranche témoin ainsi obtenue et mesurée dans un réacteur d'épitaxie et l'on a appliqué un traitement thermique à 1100°C pendant six minutes. Une fois la tranche ressortie du réacteur on a effectué de nouvelles mesures de résistance aux mêmes emplacements que les premières mesures. On a obtenu des résistances de couche d'une valeur de l'ordre de 21 ohms/carré keV et on a calculé les différences entre ces nouvelles valeurs et les précédentes. Ces différences présentaient des fluctuations de quelques pourcents révélant des variations de température de quelques degrés.

On a donc obtenu une méthode extrêmement sensible et fiable de mesure de la température d'une tranche et de sa cartographie dans un réacteur d'épitaxie sous une circulation de gaz neutre. On a également constaté que les mesures obtenues ne dépendaient pratiquement pas de la pression dans l'enceinte ni du flux de gaz neutre. La mesure des écarts de résistance constitue donc pratiquement une mesure absolue des variations de température et pourra être utilisée directement pour un réglage des lampes de chauffage.

La demanderesse estime que la forte variation de résistance obtenue (de 20 à 21 ohms) résulte essentiellement d'une exodiffusion de l'arsenic se produisant dans le réacteur d'épitaxie. Cette exodiffusion ne se produit par contre pas pendant la préparation de la tranche témoin. En effet pendant le recuit d'activation et de redistribution, qui peut être effectué à température élevée et pendant une durée importante, l'exodiffusion peut être évitée par la présence d'une couche d'oxyde.

Bien entendu, la présente invention est susceptible de nombreuses variantes et modifications. Notamment, on pourra utiliser d'autres dopants que l'arsenic, par exemple le phosphore ou le bore. On vérifiera toutefois que ces autres dopants sont aussi sensibles que l'arsenic pour lequel le phénomène d'appauvrissement en surface dû à l'évaporation et à la rediffusion vers la surface paraît particulièrement satisfaisant.

Bien que, dans un exemple de mise en oeuvre de l'invention, on ait indiqué un recuit très long de la tranche témoin, la phase essentielle est que cette tranche témoin ait subi un recuit d'activation complet, c'est-à-dire que l'on pourrait se contenter d'un passage dans un four de recuit thermique rapide.

D'autres moyens de chauffage réglables que des lampes pourront être utilisés.

On a décrit le procédé selon la présente invention comme un procédé de réglage de l'homogénéité de température dans un réacteur d'épitaxie en effectuant des mesures de résistances en plusieurs points d'une plaque témoin. Ce procédé pourra être utilisé en effectuant des mesures en un seul point d'une tranche pour vérifier, par exemple lors d'une remise en route d'un réacteur d'épitaxie que l'on a bien retrouvé les conditions d'un réglage antérieur.

## Revendications

1. Procédé d'étalonnage en température d'un réacteur d'épitaxie, **caractérisé en ce qu'**il comprend les étapes suivantes :
a) préparer une tranche témoin (10) en silicium monocristallin ayant subi sur au moins l'une de ses faces une implantation d'un dopant suivie d'un recuit d'activation pour former une couche diffusée (22) ;
b) mesurer la résistance de couche de ladite couche diffusée en un point de la surface de la tranche ;
c) placer la tranche témoin dans le réacteur d'épitaxie, celui-ci étant réglé à une température visée en présence d'un flux de gaz neutre ; et
d) mesurer à nouveau la résistance de couche au même point et calculer la différence entre les deux valeurs de résistance de couche, cette différence traduisant le cycle thermique subi par la tranche témoin pendant son séjour dans le réacteur d'épitaxie.

2. Procédé selon la revendication 1, **caractérisé en ce que** la tranche témoin subit un recuit d'activation et un recuit de redistribution en atmosphère oxydante.

3. Procédé selon la revendication 1, **caractérisé en ce que** la tranche témoin est d'un premier type de conductivité, le dopant étant du deuxième type de conductivité.

4. Procédé selon la revendication 3, **caractérisé en ce que** la tranche témoin est une tranche faiblement dopée de type P, le dopant étant de l'arsenic.

5. Procédé selon la revendication 1, **caractérisé en ce que** les mesures de résistance sont effectuées en une pluralité de points de la tranche témoin, les écarts entre les différences de résistance traduisant le cycle thermique subi par la tranche témoin aux points considérés.

6. Procédé selon la revendication 1 ou 5, **caractérisé en ce qu'**il comprend en outre l'étape consistant à ajuster le réglage de moyens de chauffage du réacteur d'épitaxie en fonction des résultats d'étalonnage obtenus.

## Claims

1. A method for calibrating the temperature of an epitaxy reactor, **characterized in that** it includes the steps of:
a) preparing a reference wafer (10) of monocrystalline silicon having undergone on at least one of its surfaces an implant of a doping followed by an activation annealing to form a diffused layer (22);
b) measuring the sheet resistance of the diffused layer at one point of the surface of the wafer;
c) placing the reference wafer in the epitaxy reactor, this reactor being set at a desired temperature in the presence of a neutral gas flow; and
d) once again measuring the sheet resistance at the same point and calculating the difference between the two values of sheet resistance, this difference translating the thermal cycle undergone by the reference wafer during its stay in the epitaxy reactor.

2. A method according to claim 1, **characterized in that** the reference wafer undergoes an activation annealing and a drive-in annealing in an oxidizing atmosphere.

3. A method according to claim 1, **characterized in that** the reference wafer is of a first type of conductivity, the doping being of the second type of conductivity.

4. A method according to claim 3, **characterized in that** the reference wafer is a lightly doped P-type wafer, the doping being arsenic.

5. A method according to claim 1, **characterized in that** the resistance measurements are performed in a plurality of points of the reference wafer, the variations between the differences in resistance translating the thermal cycle undergone by the reference wafer at the points considered.

6. A method according to claim 1 or 5, **characterized in that** it further includes the step of adjusting the setting of means for heating the epitaxy reactor according to the calibration results obtained.

## Patentansprüche

1. Verfahren zur Temperaturkalibrierung eines Epitaxie-Reaktors, **dadurch gekennzeichnet, daß** das Verfahren die folgenden Stufen bzw. Schritte umfaßt:
a) Bereitstellen eines Kalibrier- bzw. Musterwafers (10) aus monokristallinem Silizium, der an wenigstens einer seiner Oberflächen eine Implantation einer Dotierungssubstanz erfahren hat, mit nachfolgender Aktivierungsvergütung bzw. -temperung zur Bildung einer Diffusionsschicht (22);
b) Messen des Schichtwiderstands der genannten Diffusionsschicht in einem Oberflächenpunkt des Wafers;
c) Einbringen des Musterwafers in den Epitaxial-Reaktor, der auf eine gewünschte Temperatur in Gegenwart eines Neutralgasflußes geregelt wird;
d) erneutes Messen des Schichtwiderstands im selben Punkt und Berechnen der Differenz zwischen den beiden Schichtwiderstandswerten, wobei diese Differenz den thermischen Zyklus widerspiegelt, welchen der Musterwafer während seines Aufenthalts in dem Epitaxialreaktor erfahren hat.

2. Verfahren nach Anspruch 1, **dadurch gekennzeichnet, daß** der Musterwafer einer Aktivierungsvergütung bzw.-temperung und einer Neuverteilungs-Vergütung bzw. -temperung in einer oxydierenden Atmosphäre unterworfen wird.

3. Verfahren nach Anspruch 1, **dadurch gekennzeichnet, daß** der Musterwafer von einem ersten Leitfähigkeitstyp und die Dotierungssubstanz vom zweiten Leitfähigkeitstyp ist.

4. Verfahren nach Anspruch 3, **dadurch gekennzeichnet, daß** der Musterwafer ein schwach P-dotierter Wafer ist, mit Arsen als Dotierungssubstanz.

5. Verfahren nach Anspruch 1, **dadurch gekennzeichnet, daß** die Widerstandsmessungen in mehreren Punkten des Musterwafers durchgeführt werden, und daß die Abstände bzw. Abweichungen zwischen den Widerstandsdifferenzen den thermischen Zyklus widerspiegeln, welchen der Musterwafer an den betrachteten Punkten erfahren hat.

6. Verfahren nach Anspruch 1 oder 5, **dadurch gekennzeichnet, daß** das Verfahren des weiteren den Schritt der Einstellung der Regelung der Heizvorrichtungen des Epitaxial-Reaktors in Abhängigkeit von den erhaltenen Kalibrierergebnissen umfaßt.
